# EUROPÄISCHE PATENTSCHRIFT

(11) **EP 3 186 648 B1**
(45) Veröffentlichungstag und Bekanntmachung des Hinweises auf die Patenterteilung: **01.08.2018**
(21) Anmeldenummer: 15756386.7
(22) Anmeldetag: 24.08.2015
(51) Int. Cl.: G01R 31/02

(54) **KABELTESTER UND VERFAHREN ZUM TESTEN EINES N-POLIGEN KABELS**
CABLE TESTER AND A METHOD FOR TESTING AN N-POLE CABLE
TESTEUR DE CÂBLES ET PROCÉDÉ DE TEST D'UN CÂBLE À N PÔLES

(30) Priorität: 26.08.2014 AT 505902014
(43) Veröffentlichungstag der Anmeldung: 05.07.2017
(73) Patentinhaber: AVL DiTest GmbH, 8020 Graz (AT)
(72) Erfinder: KOHL, Anton, A-8263 Großwilfersdorf (AT); LUCCHINI, Jean-Marc, A-8081 Empersdorf (AT); TETYCZKA, Bernd, A-8045 Graz (AT)
(74) Vertreter: Patentanwälte Pinter & Weiss OG
(86) Internationale Anmeldenummer: PCT/EP2015/069367
(87) Internationale Veröffentlichungsnummer: WO 2016/030332

(56) Entgegenhaltungen:
- EP-A1- 2 743 712
- CN-A- 102 520 308
- US-A- 5 532 601

## Beschreibung

Die gegenständliche Erfindung betrifft einen Kabeltester mit einer ersten Testereinheit mit einer ersten Steuereinheit und einer zweiten Testereinheit mit einer zweiten Steuereinheit, wobei in der ersten Testereinheit eine von der ersten Steuereinheit gesteuerte erste Selektionsschaltung vorgesehen ist, die mit einem erste Stecker an der erste Testereinheit verbunden ist und in der zweiten Testereinheit eine von der zweiten Steuereinheit gesteuerte zweite Selektionsschaltung vorgesehen ist, die mit einem zweiten Stecker an der zweiten Testereinheit verbunden ist. Weites betrifft die Erfindung ein Verfahren zur Durchführung eines Funktionstest an einem n-poligen Kabel mit einer Anzahl von Einzelleitern mit einem Kabeltester mit einer ersten Testereinheit mit einer ersten Steuereinheit und einer zweiten Testereinheit mit einer zweiten Steuereinheit, wobei eine erste Selektionsschaltung in der ersten Testereinheit von der ersten Steuereinheit gesteuert wird und eine zweite Selektionsschaltung in der zweiten Testereinheit von der zweiten Steuereinheit gesteuert wird, wobei ein zu testendes Kabel mit einem Ende an einen mit der ersten Selektionsschaltung verbundenen ersten Stecker der ersten Testereinheit und mit dem anderen Ende an einen mit der zweiten Selektionsschaltung verbundenen zweiten Stecker der zweiten Testereinheit verbunden und zur Durchführung des Tests ein Einzelleiter des Kabels von der ersten Selektionsschaltung und zweiten Selektionsschaltung durchgeschaltet wird.

Um ein n-poliges Kabel zu testen wurde das Kabel an beiden Enden bisher ausgesteckt und die einzelnen Leiter des n-poligen Kabels wurden einzeln mittels eines Multimeters getestet, beispielsweise durch eine Widerstandsmessung. Dieses Vorgehen ist nachvollziehbar zeitaufwendig und fehleranfällig, insbesondere bei mehrpoligen Kabeln mit sehr vielen Einzelleitern. Eine Verbesserung bringen Kabeltester, bei denen das Kabel mit beiden Enden in vorgesehene Stecker am Kabeltester eingesteckt wird. Der Kabeltester führt dann den Test der Einzelleiter automatisiert durch. In beiden Fällen muss das Kabel aber abgesteckt sein und das System, in dem das Kabel im Normalbetrieb verwendet wird muss hierzu unterbrochen werden. Außerdem sind hierbei nur geringe Kabellängen möglich.

Die CN 102520308 A beschreibt einen Kabeltester mit einem Master und einem Slave Teil, an denen jeweils ein Ende des zu testenden Kabels gesteckt ist. Gesteuert über den Master werden die Einzelleiter einzeln über eine Relaisschaltung im Master und Slave automatisiert getestet. Durch die Trennung des Kabeltesters in einen Master und einen Slave können auch lange Kabel getestet werden. Allerdings muss auch hier das Kabel abgesteckt sein, um einen Test durchführen zu können. Die US 5,532,601 A offenbart einen Kabeltester, wobei eine Powerline über eine Hinleitung und eine Rückleitung mit einer Testereinheit verbunden wird. Die Testereinheit testet dabei eine über die Hin- und Rückleitung gebildete Schleife.

Es ist nun eine Aufgabe der gegenständlichen Erfindung einen Kabeltester und ein Verfahren zum Testen eines Kabels anzugeben, die es ermöglichen Kabel von nahezu beliebiger Länge auch während des Normalbetriebs des Kabels zu testen.

Diese Aufgabe wird für die Vorrichtung gelöst, indem die erste Testereinheit und die zweite Testereinheit mittels zumindest eines Testerkabels miteinander verbunden sind, wobei das Testerkabel zumindest eine Leitung für eine separate Testmasse, die von der Masse des Kabeltester verschieden ist, umfasst und zumindest in einer der ersten Testereinheit oder der zweiten Testereinheit eine Messeinheit vorgesehen ist, die eine auf die Testmasse bezogene elektrische Größe, insbesondere eine elektrische Spannung oder einen elektrischen Strom, misst, die der Kabeltester zur Durchführung eines Tests auswertet. Analog dazu zeichnet sich das erfindungsgemäße Verfahren dadurch aus, dass der zu testende Einzelleiter mit einer von der Masse des Kabeltesters verschiedenen, separaten Testmasse verbunden wird und in der ersten Testereinheit oder der zweiten Testereinheit eine auf die Testmasse bezogene elektrische Größe, insbesondere eine elektrische Spannung oder ein elektrischer Strom, gemessen und zur Durchführung des Tests ausgewertet wird. Die Verwendung einer von der Masse des Kabeltesters verschiedenen, separaten Testmasse ermöglicht es, eine Messung einer elektrischen Größe am Einzelleiter unabhängig von einer allfälligen anderen Beaufschlagung des Einzelleiters durch eine Systemspannung oder einen Systemstrom durchzuführen. Gleichzeitig wird das Kabel im Normalbetrieb, und damit eine elektrische Verbindung von Systemkomponenten durch das Kabel, durch dieses Vorgehen in keiner Weise beeinflusst. Damit ist es möglich, das Kabel nicht nur außerhalb des Betriebs, sondern auch währen des Normalbetriebs des Kabels zu testen. Das macht den Kabeltester auch noch sehr flexibel in seinen Einsatzmöglichkeiten. Durch die Trennung des Kabeltesters in eine erste Testereinheit und eine zweite Testereinheit und deren Verbindung durch ein eigenes Testerkabel, ist die mögliche Länge des zu testenden Kabels im Wesentlichen nur von der Länge des Testerkabels abhängig, womit auch sehr lange Kabel getestet werden können.

Wenn das Testerkabel eine Kommunikationsverbindung umfasst oder zwischen erster Steuereinheit und zweiter Steuereinheit eine kabellose Kommunikationsverbindung vorgesehen ist, über die die erste Steuereinheit und die zweite Steuereinheit kommunizieren, kann auf sehr vorteilhafte Weise ein Master/Slave-Betrieb des Kabeltesters implementiert werden. Das bedeutet, dass eine Testereinheit (die Mastereinheit) die andere Testereinheit (die Slaveeinheit) über die Kommunikationsverbindung steuert. Ebenfalls lässt sich damit auch ein Master/Master-Betrieb realisieren, wobei die beiden Testereinheiten über die Kommunikationsverbindung Daten austauschen können.

Mit einem Testerkabel mit einer Testleitung, die sowohl mit der ersten Selektionsschaltung als auch mit der zweiten Selektionsschaltung verbunden ist, lässt sich auf einfache Weise ein Funktionstest des Kabeltesters implementieren. Ebenso kann damit auf einfache Weise auch der Widerstand der Leitung für die Testmasse im Testerkabel abgeschätzt werden, um die auf die Testmasse bezogene Messung der elektrischen Größe, bzw. deren nachfolgende Auswertung, genauer bzw. zuverlässiger zu machen.

Wenn zumindest in einer der ersten Testereinheit oder der zweiten Testereinheit eine elektrische Energiequelle vorgesehen ist, die mit dem Ausgang der zugehörigen ersten oder zweiten Selektionsschaltung verbunden ist und an der Testmasse anliegt, kann ein zweiter Testfall in Form einer Strommessung realisiert werden.

Besonders vorteilhaft ist dabei, wenn die elektrische Energiequelle als Stromquelle ausgeführt ist und die Messeinheit eine auf die Testmasse bezogene Spannung misst, da dann eine einzige Messeinheit für die Messung einer Spannung ausreicht.

Für einen ersten Testfall wird zur Durchführung einer Spannungsmessung am durchgeschalteten Einzelleiter die auf die Testmasse bezogene Spannung gemessen und mit einem Schwellwert verglichen und ein Fehler am Einzelleiter erkannt, wenn der Schwellwert über oder unterschritten wird.

Für einen zweiten Testfall wird zur Durchführung einer Strommessung der durchgeschaltete Einzelleiter an eine auf Testmasse bezogene elektrische Energiequelle geschaltet und die dabei entstehende auf die Testmasse bezogene elektrische Größe gemessen. Hierbei kann die elektrische Energiequelle entweder als Stromquelle oder als Spannungsquelle ausgeführt sein.

In einer ganz besonders vorteilhaften Ausgestaltung der Erfindung ist ein erstes Ende des zu testenden Kabels gleichzeitig mit einer ersten Systemeinheit und einer ersten Testereinheit verbunden und das andere Ende des zu testenden Kabels gleichzeitig mit einer zweiten Systemeinheit und mit einer zweiten Testereinheit verbunden. Auf diese Weise wird ein Test des Kabels im Normalbetrieb des Kabels realisiert, ohne den Normalbetrieb zu stören.

Die gegenständliche Erfindung wird nachfolgend unter Bezugnahme auf die Figuren 1 bis 6 näher erläutert, die beispielhaft, schematisch und nicht einschränkend vorteilhafte Ausgestaltungen der Erfindung zeigen. Dabei zeigt
Fig.1 die Konfiguration eines erfindungsgemäßen Kabeltesters,
Fig.2 die Konfiguration eines erfindungsgemäßen Kabeltesters mit einem Kabel im Normalbetrieb,
Fig.3 die Durchführung einer Spannungsmessung mit dem Kabeltester,
Fig.4 die Durchführung der Spannungsmessung mit einem Fehler im Kabel,
Fig.5 die Durchführung einer Strommessung mit dem Kabeltester und
Fig.6 die Durchführung der Strommessung mit einem Fehler im Kabel.

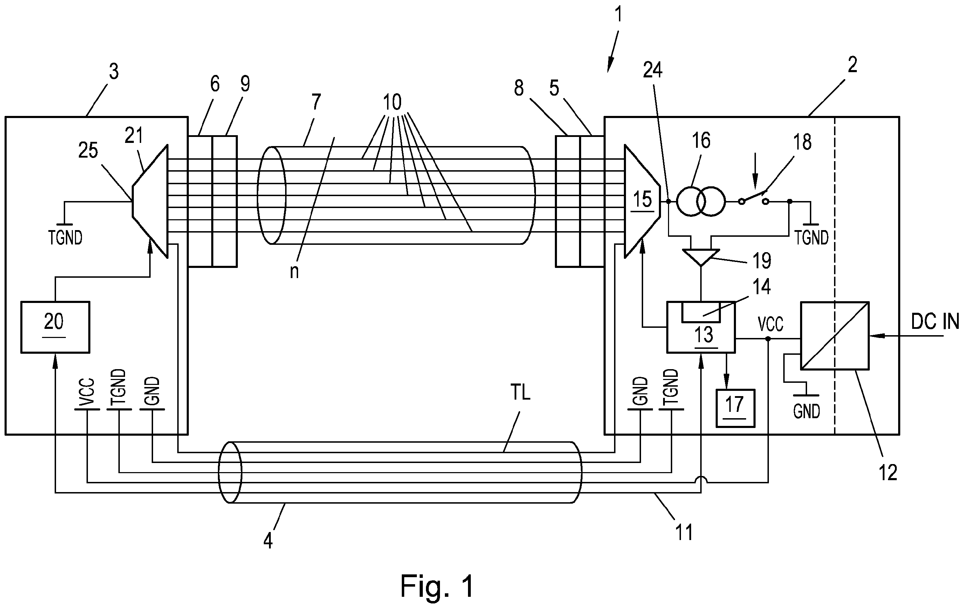

Der erfindungsgemäße Kabeltester 1 der beispielshaft in Fig.1 dargestellt ist besteht aus einer ersten erste Testereinheit 2 und einer zweiten Messeinheit 3 und einem Testerkabel 4, das die beiden Messeinheiten 2, 3 verbindet. Die erste Messeinheit 2 und die zweite Testereinheit 3 haben jeweils einen Stecker 5, 6, an die das zu testende Kabel 7 mit einer Anzahl n ≥ 1 von Einzelleitern 10 (n-polige Kabel 7) mit dessen Steckern 8, 9 angeschlossen werden kann.

Das Testerkabel 4 umfasst eine Kommunikationsverbindung 11, eine Leitung für die Versorgungsspannung VCC und eine Leitung der Masse GND des Kabeltesters 1. Zusätzlich umfasst das Testerkabel 4 auch eine zusätzliche Leitung für eine separate Testmasse TGND, deren Funktion weiter unten eingehend beschrieben wird. Die Masse GND und die Testmasse TGND sind im Kabeltester 1 nicht direkt miteinander verbunden. Das Testerkabel 4 kann auch eine Testleitung TL umfassen, wie ebenfalls weiter unten eingehend ausgeführt wird. Selbstverständlich kann das Testerkabel 4 auch aus mehreren einzelnen Kabeln bestehen und muss nicht als ein Kabel ausgeführt sein. Ebenso kann die Kommunikationsverbindung 11 auch kabellos ausgeführt sein, beispielsweise als Bluetooth- oder WLAN-Verbindung.

Durch diese Aufteilung des Kabeltesters 1 in eine erste Messeinheit 2 und eine damit über ein Testerkabel 4 verbundene zweite Messeinheit 3 kann ein nahezu beliebig langes Kabel 7 getestet werden. Die Länge des Kabels 7 ist dabei im Wesentlichen nur durch die mögliche Länge des Testerkabels 4 bzw. einer zulässigen Distanz im Fall einer kabellosen Verbindung beschränkt.

Die erste Testereinheit 2 umfasst eine Spannungsversorgung 12, die die Versorgungsspannung VCC des Kabeltesters 1 zur Verfügung stellt. Die Spannungsversorgung 12 kann auch als galvanisch getrennte Spannungsversorgung ausgeführt sein, wie durch die strichlierte Linie in der ersten Testereinheit 2 angedeutet. Durch die galvanische Trennung kann die Sicherheit des Kabeltesters 1 erhöht werden. Die Masse der Spannungsversorgung fällt vorzugsweise mit der Masse GND des Kabeltesters 1 zusammen.

Weiters ist in der ersten Testereinheit 2 eine erste Steuereinheit 13, z.B. in Form eines Mikrocontrollers oder eines programmierbaren Speicherbausteins, vorgesehen. Die erste Steuereinheit 13 kann einen Analog/Digital-Wandler (ADC) 14 aufweisen, um eine Messgröße zur Weiterverarbeitung in der ersten Steuereinheit 13 zu digitalisieren. Selbstverständlich könnte die erste Testereinheit 2 aber auch rein analog realisiert werden.

Der Stecker 5 der ersten Testereinheit 2, und damit auch die Einzelleiter 10 des n-poligen Kabels 7, ist mit einer ersten Selektionsschaltung 15, z.B. in Form eines Multiplexers oder einer Relaisschaltung, verbunden, die genau einen Einzelleiter 10 des zu testenden Kabels 7 auf einen Ausgang 24 der ersten Selektionsschaltung 15 durchschaltet. Die erste Selektionsschaltung 15 bzw. dessen Ausgang 24 ist auch mit einer elektrischen Energiequelle16, die ebenfalls von der Spannungsversorgung versorgt wird, verbunden, die mittels eines Schalters 18 hinzu- oder weggeschaltet werden kann. Die elektrische Energiequelle16 liegt aber an der Testmasse TGND und nicht an der Masse GND der Spannungsversorgung 12. Die elektrische Energiequelle 16 ist damit im Testfall wie weiter unten noch ausgeführt in einem geschlossenen Stromkreis mit der Testmasse TGND als Masse eingebunden. Die erste Selektionsschaltung 15 und der Schalter 18 werden von der ersten Steuereinheit 13 gesteuert, wie in Fig.1 angedeutet. Die elektrische Energiequelle 16 kann als Stromquelle, wie in den Figuren dargestellt, oder als Spannungsquelle ausgeführt sein.

Eine Messeinheit 19 misst eine elektrische Größe Strom I_{T} oder Spannung U_{ADC}, je nach Ausführung der elektrischen Energiequelle 16, zwischen dem Ausgang 24 der erste Selektionsschaltung 15, an dem ein Einzelleiter 10 durchgeschaltet ist, und der Testmasse TGND. In den Figuren werden durchgehend eine Stromquelle und eine Spannungsmessung dargestellt. Der erfindungsgemäße Kabeltester 1 kann aber gleichwertig auch mit einer Spannungsquelle und einer Strommessung als Messeinheit 19 ausgeführt sein. Entscheidend für die Erfindung ist, dass die elektrische Größe Strom oder Spannung gegen die Testmasse TGND gemessen wird und die Testmasse TGND von der Masse GND des Kabeltesters 1 verschieden ist. Diese gemessene elektrische Größe, hier die Spannung U_{ADC}, wird als Messgröße dem ADC 14 und damit der ersten Steuereinheit 13 übermittelt und kann zur Durchführung eines Tests an einem Kabel 7 ausgewertet werden, wie unten noch eingehend ausgeführt wird.

Die erste Testereinheit 2 kann weiters noch eine Ein-/Ausgabeeinheit 17 umfassen, um den Ablauf eines Tests des Kabels 7 zu steuern und/oder um das Ergebnis des Tests anzuzeigen. Die erste Testereinheit 2 kann aber natürlich auch eine Schnittstelle zu einem Datennetzwerk, z.B. ein LAN, WAN, WLAN, oder ähnliches, aufweisen, um die erste Testereinheit 2 von einer entfernten Recheneinheit zu steuern.

In der zweiten Testereinheit 3 ist eine zweite Steuereinheit 20, z.B. in Form eines Mikrocontrollers oder eines programmierbaren Speicherbausteins, vorgesehen, die über die Kommunikationsverbindung 11 des Testerkabels 4, z.B. eine serielle Schnittstellte oder ein Datenbus, mit der ersten Steuereinheit 13 verbunden ist. Die zweite Steuereinheit 20 und die erste Steuereinheit 13 können über die Kommunikationsverbindung 11 Daten und Befehle austauschen. Insbesondere kann die zweite Steuereinheit 20 über die Kommunikationsverbindung 11 von der ersten Steuereinheit 13 gesteuert werden.

Weiters ist in der zweiten Testereinheit 3 eine zweite Selektionsschaltung 21, z.B. in Form eines Multiplexers oder einer Relaisschaltung, vorgesehen, die von der zweiten Steuereinheit 20 gesteuert wird. Die zweite Selektionsschaltung 21 ist einerseits mit dem Stecker 6 der zweiten Testereinheit 3, und damit mit den Einzelleitern 10 des Kabels 7, und andererseits mit deren Ausgang 25 mit der Testmasse TGND verbunden.

Die erste Testereinheit 2 und die zweite Testereinheit 3 können hardwaremäßig auch identisch aufgebaut sein und für den Einsatz entsprechend als Master oder Slave konfiguriert sein. Allerdings ist auch eine Konfiguration als Master und Master vorstellbar.

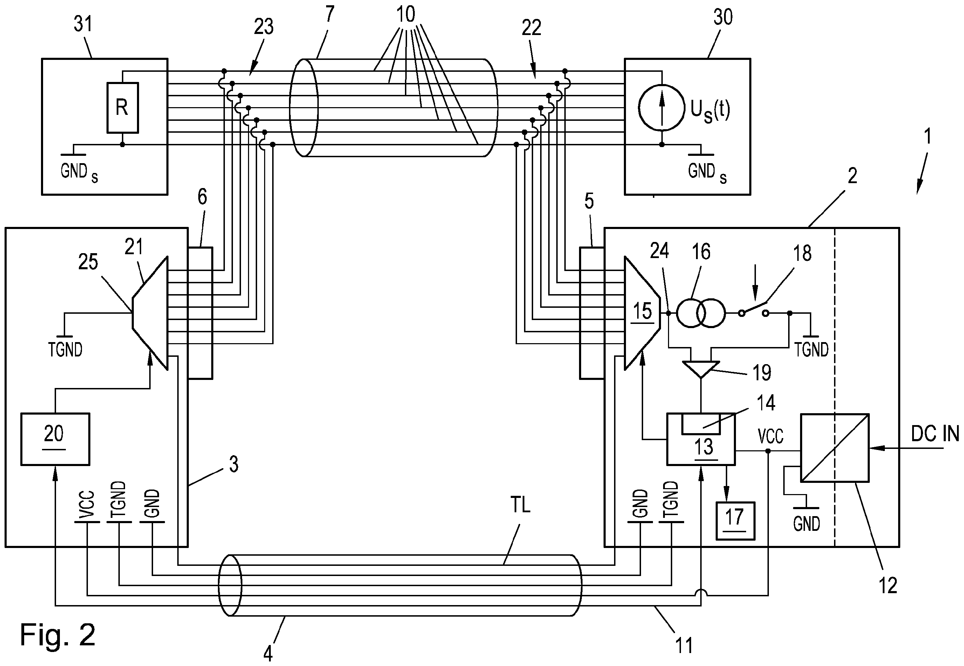

Zum Durchführen eines Tests am Kabel 7 wird über die erste Steuereinheit 13 ein Einzelleiter 10 des Kabels 7 durch die erste Selektionsschaltung 15 durchgeschaltet. Über die Kommunikationsverbindung 11 wird die zweite Testereinheit 3 über die zweite Steuereinheit 20 und die zweite Selektionsschaltung 21 veranlasst, denselben Einzelleiter 10 des Kabels 7 durchzuschalten. Auf diese Weise wird jeweils einer der Einzelleiter 10 für den Test ausgewählt und mit der Testmasse TGND verbunden. Die Einzelleiter 10 können somit automatisiert einzeln und hintereinander getestet werden. Das Testen des Kabels 7 wird nachfolgend anhand der Figuren 2 bis 6 am Beispiel eines n-poligen Kabels 7 im Normalbetrieb im Detail beschrieben.

Im Normalbetrieb verbindet das n-polige Kabel 7 eine erste Systemeinheit 30 mit einer zweiten Systemeinheit 31. An den Einzelleitern 10 des Kabels 7 können gegenüber einer Systemmasse GND_{S} unterschiedliche und zeitlich variierende Systemspannungen U_{S}(t) anliegen, wie in Fig.2 am Beispiel des ersten Einzelleiters 10 angedeutet. Die Systemmasse GND_{S} ist von der Testmasse TGND verschieden. Gleichzeitig ist das Kabel 7 wie oben beschrieben mit dem Kabeltester 1 verbunden. Hierzu kann an den Kabelenden des Kabels 7 jeweils ein Y-Adapter 22, 23 (angedeutet in Fig.2) vorgesehen sein, der es ermöglicht, das Kabel 7 sowohl an die erste und zweite Systemeinheit 30, 21 als auch an die erste und zweite Testereinheit 2, 3 anzuschließen. Anstelle eines vorteilhaften Y-Adapters 22, 23 können natürlich auch andere Verbindungsmöglichkeiten vorgesehen sein, wie z.B. Krokodilklemmen, Steckpins, etc. Der Kabeltester 1 kann daher auch nur bei Bedarf an das Kabel 7 angeschlossen werden, ohne den Normalbetrieb zu stören. Für den Kabeltest muss das Kabel 7 somit nicht von der ersten und zweiten Systemeinheit 30, 21 getrennt werden. Allerdings ist es natürlich auch möglich, ein nicht im Betrieb befindliches Kabel 7 zu testen, indem dieses wie in Fig.1 mit dessen Steckern 8, 9 mit dem Kabeltester 1 verbunden wird.

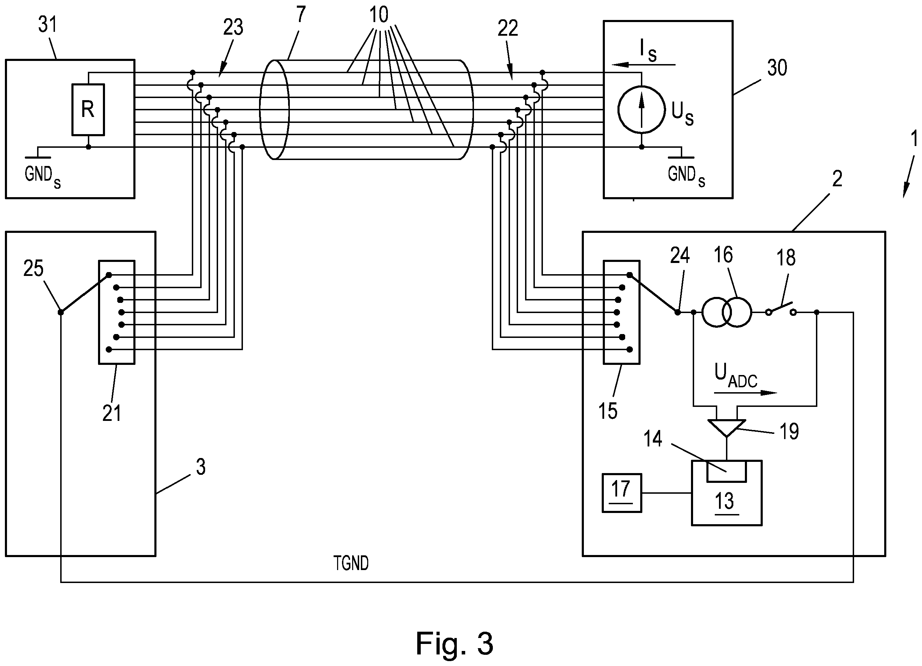

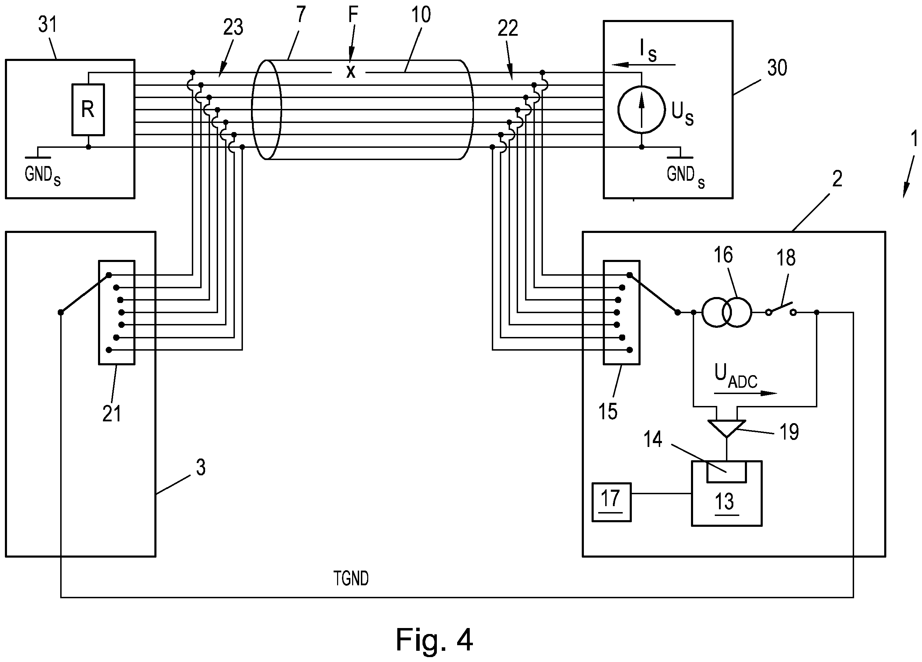

Mit Fig.3 wird als erster Testfall eine Spannungsmessung beschrieben, wobei hier nur mehr die für diesen Test relevanten Teile des Kabeltesters 1 dargestellt sind. Wie oben beschrieben wird ein Einzelleiter 10 des zu testenden n-poligen Kabels 7 für den Test durchgeschaltet. Die elektrische Energiequelle 16 ist abgeschaltet. Die Messeinheit 19 misst die Spannung U_{ADC}, die zwischen der ersten Selektionsschaltung 15 bzw. deren Ausgang 24 und der zweiten Selektionsschaltung 21 bzw. deren Ausgang 25, die auf Testmasse TGND liegt, abfällt, also ein Spannungspotential gegenüber der Testmasse TGND. Im Wesentlichen, unter Vernachlässigung von anderen Leitungswiderständen, wird hierdurch der Spannungsabfall am Einzelleiter 10 des zu testenden Kabels 7 gemessen. Dieser Spannungsabfall ist aufgrund der Messung gegenüber der Testmasse TGND vollkommen unabhängig von der Systemspannungen U_{S} und einem Systemstrom I_{S} über den Einzelleiter 10. Dieser Spannungsabfall U_{ADC} wird bei einem ordnungsgemäßen Einzelleiter 10 sehr klein sein, in der Regel im Bereich von >0V bis <1V. Nachdem die elektrischen Eigenschaften des Kabels 7, wie z.B. die Leitungswiderstände, bekannt sind, oder zumindest abgeschätzt werden können, kann der zu erwartenden Spannungsabfall U_{ADCsoll} auch im Vorfeld abgeschätzt und als Sollwert mit dem gemessenen Spannungsabfall U_{ADC} verglichen werden. Durch Vergleich des gemessenen Spannungsabfalls U_{ADC} mit einem Schwellwert U_{TS}, z.B. in Form des erwartenden Spannungsabfall U_{ADCsoll} oder eines vorgegebenen Spannungswertes, kann damit festgestellt werden, ob der Einzelleiter 10 beschädigt, insbesondere unterbrochen, ist oder nicht. Dieser Fehlerfall ist in Fig.4 dargestellt. Aufgrund eines Fehlers F im Einzelleiter 10, hier eine Unterbrechung, wird im Wesentlichen die Systemspannung U_{S} gemessen, also U_{ADC}∼U_{S}, die in der Regel deutlich größer ist, als der normale Spannungsabfall über den unbeschädigten Einzelleiter 10. Das Ergebnis des Tests kann an der Ein-/Ausgabeeinheit 17 angezeigt werden.

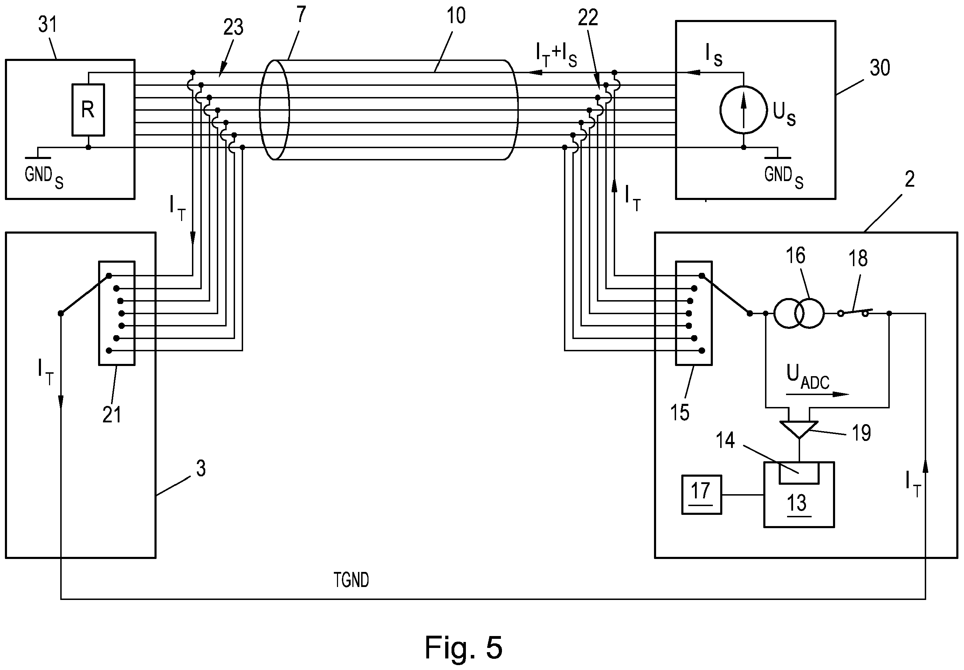

Mit Fig.5 wird als zweiter Testfall eine Strommessung beschrieben, wobei hier nur mehr die für diesen Test relevanten Teile des Kabeltesters 1 dargestellt sind. Wie oben beschrieben wird ein Einzelleiter 10 des zu testenden Kabels 7 für den Test durchgeschaltet. Die elektrische Energiequelle 16 ist für die Strommessung eingeschaltet (bzw. Schalter 18 geschlossen), wodurch ein Teststrom I_{T} fließt. Systemabhängig kann der Teststrom I_{T} im Hochvoltbereich im kA-Bereich und für kleine Steuerleitungen im mA-Bereich sein.

Die Messeinheit 19 misst bei Verwendung einer Stromquelle als elektrische Energiequelle 16 die Spannung U_{ADC}, die zwischen der erste Selektionsschaltung 15 und der zweite Selektionsschaltung 21, die auf Testmasse TGND liegt, abfällt, also wieder ein Spannungspotential gegenüber der Testmasse TGND. Im Falle einer Spannungsquelle als elektrische Energiequelle 16 würde die Messeinheit 19 den im durch die Testmasse TGND und den Einzelleiter 10 gebildeten Stromkreis fließenden Teststrom I_{T} messen. Zu bevorzugen ist aber die Verwendung einer Stromquelle, da dann für beide Testfälle die Messeinheit 19 eine Spannung misst.

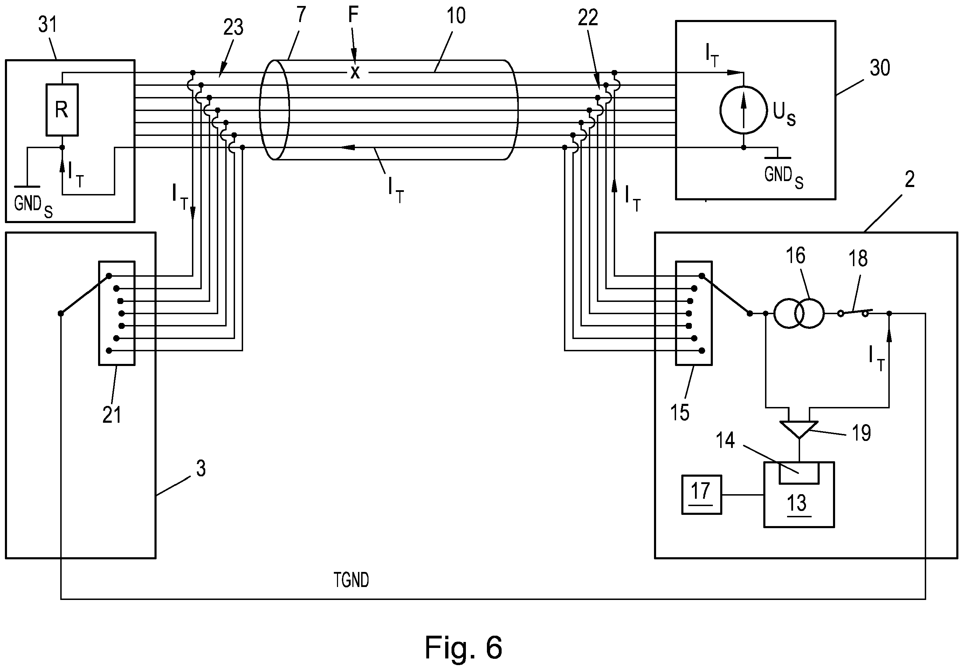

Der Teststrom I_{T} fließt über die erste Testereinheit 2 in den zu testenden, durchgeschalteten Einzelleiter 10 des zu testenden Kabels 7. Dort überlagern sich der Systemstrom I_{S}, der im Normalbetrieb über das Kabel 7 fließt, und der Teststrom I_{T}. Am gegenüberliegenden Ende des Kabels 7 fließt der Teststrom I_{T} in die zweite Testereinheit 3 3 und von dort über die Testmasse TGND zurück zur ersten Testereinheit 2. Nachdem die Systemmasse GND_{S} und die Testmasse TGND elektrisch getrennt sind, lassen sich der Systemstrom I_{S} und der Teststrom I_{T} sauber trennen und der Teststrom I_{T} beeinflusst in keiner Weise die erste oder zweite Systemeinheit 30, 31. Die Spannungsmesseinheit 19 misst im gezeigten Ausführungsbeispiel wieder die Spannung U_{ADC} (bzw. den Teststrom I_{T} Im Falle einer Spannungsquelle), die zwischen der ersten Selektionsschaltung 15 und der zweiten Selektionsschaltung 21, die auf Testmasse TGND liegt, abfällt, also ein Spannungspotential gegenüber der Testmasse TGND. Dieser Spannungsabfall ist aufgrund der Messung gegenüber der Testmasse TGND vollkommen unabhängig von der Systemspannungen U_{S} und einem Systemstrom I_{S} über den Einzelleiter 10. Die gemessene Spannung U_{ADC} ergibt sich im Wesentlichen aus dem Widerstand R_{W} des Einzelleiters 10, dem Widerstand R_{K} der Retourleitung der Testmasse TGND im Testerkabel 4 und dem Teststrom I_{T} zu U_{ADC} = (R_{W} + R_{K}) * I_{T}. Gleiches gilt in analoger Weise für eine Spannungsquelle mit Nennspannung U_{ADC} als elektrische Energiequelle 16. Nachdem die elektrischen Eigenschaften des Kabels 7 und des Testerkabels 4 , wie z.B. die Leitungswiderstände, bekannt sind, oder zumindest abgeschätzt werden können, kann der zu erwartenden Spannungsabfall U_{ADCsoll} (bzw. der zu erwartende Teststrom I_{Tsoll}) auch im Vorfeld abgeschätzt und als Sollwert mit dem gemessenen Spannungsabfall U_{ADC} (bzw. Teststrom I_{T}) verglichen werden. Durch Vergleich des gemessenen Wertes mit einem Schwellwert U_{TS} (bzw. I_{TS}), z.B. in Form des erwartenden Spannungsabfall U_{ADCsoll} oder eines vorgegebenen Spannungswertes, kann damit festgestellt werden, ob der Einzelleiter 10 beschädigt, insbesondere unterbrochen, ist oder nicht. Dieser Fehlerfall ist in Fig.6 dargestellt.

Aufgrund eines Fehlers F im Einzelleiter 10, hier eine Unterbrechung, kann der Teststrom I_{T} nicht mehr über den Einzelleiter 10 fließen, sondern fließt über die Systemmasse GND_{S} und die zweite Systemeinheit 31 zur zweiten Testereinheit 3, wie in Fig.6 dargestellt. Der in der ersten Testereinheit 2 gemessene Spannungsabfall U_{ADC} ist damit deutlich größer, da zusätzlich Spannung an den Innenwiderständen R der zweiten Systemeinheit 31 und R_{S} der ersten Systemeinheit 30 abfällt. Im Falle einer Strommessung, wäre der gemessene Teststrom I_{T} im Fehlerfall kleiner. Der gemessene Spannungsabfall U_{ADC} ergibt sich demnach im Fehlerfall zu U_{ADC} = (R_{W} + R_{K} + R + R_{S}) * I_{T}. Gleiches gilt in analoger Weise für eine Spannungsquelle mit Nennspannung U_{ADC} als elektrische Energiequelle 16. Der Fehlerfall ist damit durch Vergleich mit einem Schwellwert U_{TS} bzw. I_{TS} eindeutig erkennbar. Das Ergebnis des Tests kann wieder an der Ein-/Ausgabeeinheit 17 angezeigt werden. Die Schwellwerte U_{TS} bzw. I_{TS} der beiden Testfälle haben in der Regel nicht dieselben Werte.

Die Testleitung TL der Kommunikationsverbindung 11 kann auch verwendet werden, um den Widerstand der Retourleitung der Testmasse TGND in der Kommunikationsverbindung 11 abzuschätzen. Hierzu wird die Testleitung TL in der ersten Testereinheit 2 und zweiten Testereinheit 3, wie ein Einzelleiter 10, an die erste Selektionsschaltung 15 und zweite Selektionsschaltung 21 angeschlossen. Damit kann die Testleitung TL durchgeschaltet und mit einem Teststrom I_{T} beaufschlagt werden und es kann dabei durch Messung des entstehenden Spannungsabfalls U_{ADC} und Anwendung des Ohm'schen Gesetzes auf den Widerstand R_{K} der Testleitung TL, der in etwa dem Widerstand der Retourleitung der Testmasse TGND entspricht, geschlossen werden.

Die Testleitung TL kann aber auch für eine einfache Funktionsprüfung des Kabeltesters 1 verwendet werden. Wird die Testleitung TL durchgeschaltet und ein Teststrom I_{T} oder eine Spannung U_{ADC} angelegt, dann muss in der ersten Testereinheit 2 ein Spannungsabfall U_{ADC} oder ein Teststrom I_{T} gemessen werden. Falls das nicht der Fall ist, muss ein Fehler vorliegen, beispielsweise in der Kommunikation zwischen ersten Testereinheit 2 und zweiten Testereinheit 3.

Für einen Test eines n-poligen Kabels 7 kann als Testfall entweder die oben beschriebene Spannungsmessung oder Strommessung, oder beide, verwendet werden. Im Falle einer Spannungsmessung kann es beim Testen eines Einzelleiters 10 passieren, dass die Systemspannung U_{S} gerade Null ist (z.B. bei einem logischen 0 einer Binärleitung). D.h., dass bei einer Spannungsmessung an einem Kabel 7 im Normalbetrieb nicht mit Sicherheit auf ein intaktes Kabel 7 bzw. einen intakten Einzelleiter 10 geschlossen werden kann, wenn eine kleine Spannung U_{ADC} gemessen wird. Da diese niedrige Spannung U_{ADC} auch daher rühren kann, dass der Einzelleiter 10 einen Fehler F aufweist und man dabei die Systemspannung U_{S}∼ 0 messen würde. In diesem Fall sollte die Spannungsmessung durch den Testfall einer Strommessung ergänzt werden, da damit sicher auf einen Fehler F geschlossen werden kann.

In den obigen Ausführungsbeispielen wird die Messung der elektrischen Größen für den Test immer in der ersten Testereinheit 2 durchgeführt. Selbstverständlich ist es aber auch denkbar, diese Messung in der zweiten Testereinheit 3 durchzuführen. Die obigen Ausführungen gelten dabei analog. Hierzu kann wie in der ersten Testereinheit 2 in der zweiten Testereinheit 3 eine Messeinheit 19 und ein ADC 14 vorgesehen sein. Gemessen wird wieder bezogen auf die Testmasse TGND. Der Messwert kann von der zweiten Testereinheit 3 über die Kommunikationsverbindung 11 auch an die erste Testereinheit 2 bzw. an die erste Steuereinheit 13 übermittelt und dort ausgewertet werden. Die Auswertung kann aber ebenfalls in der zweiten Testereinheit 3 bzw. der zweiten Steuereinheit 20 erfolgen. Auch die Anzeige des Ergebnisses eines Tests kann an der zweiten Testereinheit 3 bzw. auch an beiden Testereinheiten 2, 3 erfolgen.

## Patentansprüche

1. Kabeltester mit einer ersten Testereinheit (2) mit einer ersten Steuereinheit (13) und einer zweiten Testereinheit (3) mit einer zweiten Steuereinheit (20), wobei in der ersten Testereinheit (2) eine von der ersten Steuereinheit (13) gesteuerte erste Selektionsschaltung (15) vorgesehen ist, die mit einem erste Stecker (5) an der ersten Testereinheit (2) verbunden ist und in der zweiten Testereinheit (3) eine von der zweiten Steuereinheit (20) gesteuerte zweite Selektionsschaltung (21) vorgesehen ist, die mit einem zweiten Stecker (6) an der zweiten Testereinheit (3) verbunden ist, **dadurch gekennzeichnet, dass** die erste Testereinheit (2) und die zweite Testereinheit (3) mittels zumindest eines Testerkabels (4) miteinander verbunden sind, wobei das Testerkabel (4) zumindest eine Leitung für eine separate elektrische Testmasse (TGND), die von der elektrischen Masse (GND) des Kabeltesters (1) verschieden ist, umfasst **und dass** zumindest in einer der ersten Testereinheit (2) oder der zweiten Testereinheit (3) eine Messeinheit (19) vorgesehen ist, die eine auf die Testmasse (TGND) bezogene elektrische Größe (U_{ADC}, I_{T}) misst, die der Kabeltester (1) zur Durchführung eines Tests auswertet.

2. Kabeltester nach Anspruch 1, **dadurch gekennzeichnet, dass** das Testerkabel (4) eine Kommunikationsverbindung (11) umfasst, über die die erste Steuereinheit (13) und die zweite Steuereinheit (20) kommunizieren.

3. Kabeltester nach Anspruch 1, **dadurch gekennzeichnet, dass** zwischen erster Steuereinheit (13) und zweiter Steuereinheit (20) eine kabellose Kommunikationsverbindung vorgesehen ist..

4. Kabeltester nach Anspruch 1, **dadurch gekennzeichnet, dass** das Testerkabel (4) eine Testleitung (TL) umfasst, die sowohl mit der ersten Selektionsschaltung (15) als auch mit der zweiten Selektionsschaltung (21) verbunden ist.

5. Kabeltester nach einem der Ansprüche 1 bis 4, **dadurch gekennzeichnet, dass** zumindest in einer der ersten Testereinheit (2) oder der zweiten Testereinheit (3) eine elektrische Energiequelle (16) vorgesehen ist, die mit dem Ausgang (24, 25) der zugehörigen ersten oder zweiten Selektionsschaltung (15, 21) verbunden ist und an der Testmasse (TGND) anliegt.

6. Kabeltester nach Anspruch 5, **dadurch gekennzeichnet, dass** als elektrische Energiequelle (16) eine Stromquelle vorgesehen ist und die Messeinheit (19) eine auf die Testmasse (TGND) bezogene Spannung (U_{ADC}) misst.

7. Kabeltester nach Anspruch 5, **dadurch gekennzeichnet, dass** als elektrische Energiequelle (16) eine Spannungsquelle vorgesehen ist und die Messeinheit (19) einen auf die Testmasse (TGND) bezogenen Strom (I_{T}) misst.

8. Verfahren zur Durchführung eines Funktionstest an einem n-poligen Kabel (7) mit einer Anzahl von Einzelleitern (10) mit einem Kabeltester (1) mit einer ersten Testereinheit (2) mit einer ersten Steuereinheit (13) und einer zweiten Testereinheit (3) mit einer zweiten Steuereinheit (20), wobei eine erste Selektionsschaltung (15) in der ersten Testereinheit (2) von der ersten Steuereinheit (13) gesteuert wird und eine zweite Selektionsschaltung (21) in der zweiten Testereinheit (3) von der zweiten Steuereinheit (20) gesteuert wird, wobei das zu testende Kabel (7) mit einem ersten Ende an einen mit der ersten Selektionsschaltung (15) verbundenen ersten Stecker (5) der ersten Testereinheit (2) und mit dem anderen Ende an einen mit der zweiten Selektionsschaltung (21) verbundenen zweiten Stecker (6) der zweiten Testereinheit (3) verbunden und zur Durchführung des Tests ein Einzelleiter (10) des Kabels (7) von der ersten Selektionsschaltung (15) und der zweiten Selektionsschaltung (21) durchgeschaltet wird, **dadurch gekennzeichnet, dass** der Einzelleiter (10) mit einer von der elektrischen Masse (GND) des Kabeltesters (1) verschiedenen, separaten Testmasse (TGND) verbunden wird **und dass** in der ersten Testereinheit (2) oder der zweiten Testereinheit (3) eine auf die Testmasse (TGND) bezogene elektrische Größe (U_{ADC}, I_{T}) gemessen und zur Durchführung des Tests ausgewertet wird.

9. Verfahren nach Anspruch 8, **dadurch gekennzeichnet, dass** zur Durchführung einer Spannungsmessung am durchgeschalteten Einzelleiter (10) die auf die Testmasse (TGND) bezogene Spannung (U_{ADC}) gemessen wird und mit einem Schwellwert (U_{TS}) verglichen wird und ein Fehler am Einzelleiter (10) erkannt wird, wenn der Schwellwert (U_{TS}) überschritten wird.

10. Verfahren nach Anspruch 8, **dadurch gekennzeichnet, dass** zur Durchführung einer Strommessung der durchgeschaltete Einzelleiter (10) an eine auf Testmasse (TGND) bezogene elektrische Energiequelle (16) geschaltet wird und die dabei entstehende auf die Testmasse (TGND) bezogene elektrische Größe (U_{ADC}, I_{T}) gemessen wird.

11. Verfahren nach Anspruch 10, **dadurch gekennzeichnet, dass** der durchgeschaltete Einzelleiter (10) an eine Stromquelle als elektrische Energiequelle (16) geschaltet wird und der Einzelleiter (10) mit einem Teststrom (I_{T}) beaufschlagt wird und die auf die Testmasse (TGND) bezogene Spannung (U_{ADC}) gemessen wird und mit einem Schwellwert (U_{TS}) verglichen wird und ein Fehler (F) am Einzelleiter (10) erkannt wird, wenn der Schwellwert (U_{TS}) überschritten wird.

12. Verfahren nach Anspruch 10, **dadurch gekennzeichnet, dass** der durchgeschaltete Einzelleiter (10) an eine Spannungsquelle als elektrische Energiequelle (16) geschaltet wird und der Einzelleiter (10) mit einer Spannung (U_{ADC}) beaufschlagt wird und der auf die Testmasse (TGND) bezogene Teststrom (I_{T}) gemessen wird und mit einem Schwellwert (I_{TS}) verglichen wird und ein Fehler (F) am Einzelleiter (10) erkannt wird, wenn der Schwellwert (I_{TS}) unterschritten wird.

13. Verfahren nach einem der Ansprüche 8 bis 12, **dadurch gekennzeichnet, dass** das erste Ende des zu testenden Kabels (7) gleichzeitig mit einer ersten Systemeinheit (30) und der ersten Testereinheit (2) verbunden wird und das andere Ende des zu testenden Kabels (7) gleichzeitig mit einer zweiten Systemeinheit (31) und mit der zweiten Testereinheit (3) verbunden wird.

## Claims

1. A cable tester having a first tester unit (2) with a first control unit (13) and a second tester unit (3) with a second control unit (20), wherein, in the first tester unit (2), a first selection circuit (15) controlled by the first control unit (13) is provided, which is connected to a first connector (5) at the first tester unit (2), and, in the second tester unit (3), a second selection circuit (21) controlled by the second control unit (20) is provided, which is connected to a second connector (6) at the second tester unit (3), **characterized in that** the first tester unit (2) and the second tester unit (3) are interconnected by at least one tester cable (4), wherein the tester cable (4) comprises at least one line for a separate electrical test ground (TGND) that differs from the electrical ground (GND) of the cable tester (1), **and in that** a measuring unit (19) is provided in at least one of the first tester unit (2) or the second tester unit (3) which measures an electrical variable (U_{ADC}, I_{T}) relating to the test ground (TGND) which is assessed by the cable tester (1) to perform a test.

2. The cable tester as claimed in claim 1, **characterized in that** the tester cable (4) comprises a communication link (11) via which the first control unit (13) and the second control unit (20) communicate.

3. The cable tester as claimed in claim 1, **characterized in that** a wireless communication link is provided between the first control unit (13) and the second control unit (20).

4. The cable tester as claimed in claim 1, **characterized in that** the tester cable (4) comprises a test line (TL) which is connected to both the first selection circuit (15) and the second selection circuit (21).

5. The cable tester as claimed in any one of claims 1 to 4, **characterized in that** at least in one of the first tester unit (2) or the second tester unit (3), an electrical power source (16) is provided which is connected to the output (24, 25) of the associated first or second selection circuit (15, 21) and is connected to the test ground (TGND).

6. The cable tester as claimed in claim 5, **characterized in that** a current source is provided as the electrical power source (16) and the measuring unit (19) measures a voltage (U_{ADC}) relating to the test ground (TGND).

7. The cable tester as claimed in claim 5, **characterized in that** a voltage source is provided as the electrical power source (16) and the measuring unit (19) measures a current (I_{T}) relating to the test ground (TGND).

8. A method for preforming a functional test on an n-pole cable (7) having a number of individual conductors (10) using a cable tester (1) having a first tester unit (2) with a first control unit (13) and a second tester unit (3) with a second control unit (20), wherein a first selection circuit (15) in the first tester unit (2) is controlled by the first control unit (13) and a second selection circuit (21) in the second tester unit (3) is controlled by the second control unit (20), wherein the cable (7) to be tested is connected with a first end to a first connector (5) of the first tester unit (2) connected to the first selection circuit (15) and with the other end to a second connector (6) of the second tester unit (3) connected to the second selection circuit (21), and, to perform the test, an individual conductor (10) of the cable (7) is connected through by the first selection circuit (15) and the second selection circuit (21), **characterized in that** the individual conductor (10) is connected to a separate test ground (TGND) that differs from the electrical ground (GND) of the cable tester (1), **and that** an electrical variable (U_{ADC}, I_{T}) relating to the test ground (TGND) is measured in the first tester unit (2) or the second tester unit (3) and assessed to perform the test.

9. The method as claimed in claim 8, **characterized in that,** to perform a voltage measurement on the individual conductor (10) connected through, the voltage (U_{ADC}) relating to the test ground (TGND) is measured and compared to a threshold value (U_{TS}), and a fault in the individual conductor (10) is detected if the threshold value (U_{TS}) is exceeded.

10. The method as claimed in claim 8, **characterized in that,** to perform a current measurement, the individual conductor (10) connected through is switched to an electrical power source (16) relating to the test ground (TGND), and the resulting electrical variable (U_{ADC}, I_{T}) relating to the test ground (TGND) is measured.

11. The method as claimed in claim 10, **characterized in that** the individual conductor (10) connected through is switched to a current source as the electrical power source (16), and a test current (I_{T}) is applied to the individual conductor (10), and the voltage (U_{ADC}) relating to the test ground (TGND) is measured and compared with a threshold value (U_{TS}), and a fault (F) in the individual conductor (10) is detected if the threshold value (U_{TS}) is exceeded.

12. The method as claimed in claim 10, **characterized in that** the individual conductor (10) connected through is switched to a voltage source as the electrical power source (16), and a voltage (U_{ADC}) is applied to the individual conductor (10), and the test current (I_{T}) relating to the test ground (TGND) is measured and compared with a threshold value (I_{TS}), and a fault (F) in the individual conductor (10) is detected if the threshold value (I_{TS}) is undercut.

13. The method as claimed in any one of claims 8 to 12, **characterized in that** the first end of the cable (7) to be tested is simultaneously connected to a first system unit (30) and the first tester unit (2) and the other end of the cable (7) to be tested is simultaneously connected to a second system unit (31) and the second tester unit (3).

## Revendications

1. Testeur de câble comprenant une première unité de test (2) munie d'une première unité de commande (13) et une seconde unité de test (3) munie d'une seconde unité de commande (20), la première unité de test (2) comportant un premier circuit de sélection (15) qui est commandé par la première unité de commande (13) et qui est relié à un premier connecteur (5) au niveau de la première unité de test (2) et la seconde unité de test (3) comportant un second circuit de sélection (21) qui est commandé par la seconde unité de commande (20) et qui est relié à un second connecteur (6) au niveau de la seconde unité de test (3), **caractérisé en ce que** la première unité de test (2) et la seconde unité de test (3) sont reliées entre elles par au moins un câble de testeur (4), le câble de testeur (4) comportant au moins une ligne destinée à une masse de test électrique séparée (TGND) qui est différente de la masse électrique (GND) du testeur de câble (1), **et en ce que** l'une au moins parmi la première unité de test (2) ou le seconde unité de test (3) comportent une unité de mesure (19) qui mesure une grandeur électrique (U_{ADC}, I_{T}) qui est rapportée à la masse de test (TGND) et que le testeur de câble (1) évalue pour effectuer un test.

2. Testeur de câble selon la revendication 1, **caractérisé en ce que** le câble de testeur (4) comporte une liaison de communication (11) par laquelle la première unité de commande (13) et la seconde unité de commande (20) communiquent.

3. Testeur de câble selon la revendication 1, **caractérisé en ce qu'**une connexion de communication sans fil est prévue entre la première unité de commande (13) et la seconde unité de commande (20).

4. Testeur de câble selon la revendication 1, **caractérisé en ce que** le câble de test (4) comprend une ligne de test (TL) qui est reliée à la fois au premier circuit de sélection (15) et au second circuit de sélection (21).

5. Testeur de câble selon l'une des revendications 1 à 4, **caractérisé en ce que** l'une au moins parmi la première unité de test (2) ou la seconde unité de test (3) comporte une source d'énergie électrique (16) qui est reliée à la sortie (24, 25) du premier ou du deuxième circuit de sélection (15, 21) associé et est appliquée à la masse de test (TGND).

6. Testeur de câble selon la revendication 5, **caractérisé en ce que** la source d'énergie électrique (16) prévue est source de courant et l'unité de mesure (19) mesure la tension (U_{ADC}) liée à la masse de test (TGND).

7. Testeur de câble selon la revendication 5, **caractérisé en ce que** la source d'énergie électrique (16) prévue est une source de tension et l'unité de mesure (19) mesure un courant (I_{T}) lié à la masse de test (TGND).

8. Procédé pour effectuer un test fonctionnel sur un câble à n pôles (7), comprenant un certain nombre de conducteurs individuels (10), au moyen d'un testeur de câble (1) comportant une première unité de test (2) munie d'une première unité de commande (13) et une seconde unité de test (3) munie d'une seconde unité de commande (20), un premier circuit de sélection (15) de la première unité de test (2) étant commandé par la première unité de commande (13) et un second circuit de sélection (21) de la seconde unité de test (3) étant commandé par la seconde unité de commande (20), le câble à tester (7) étant relié par une première extrémité à un premier connecteur (5), relié au premier circuit de sélection (15), de la première unité de test (2) et par l'autre extrémité à un second connecteur (6), relié au second circuit de sélection (21), de la seconde unité de test (3) et, pour effectuer des tests, un conducteur individuel (10) du câble (7) est mis en communication par le premier circuit de sélection (15) et le second circuit de sélection (21), **caractérisé en ce que** le conducteur individuel (10) est relié à une masse de test séparée (TGND) différente de la masse électrique (GND) du testeur de câble (1) et **en ce que,** dans la première unité de test (2) ou la seconde unité de test (3), une grandeur électrique (U_{ADC}, I_{T}), liée à la masse de test (TGND), est mesurée et évaluée pour effectuer le test.

9. Procédé selon la revendication 8, **caractérisé en ce que,** pour effectuer une mesure de tension, la tension (U_{ADC}) liée à la masse d'essai (TGND) est mesurée sur le conducteur individuel (10) connecté et est comparée à une valeur de seuil (U_{TS}) et une erreur sur le conducteur individuel (10) est détectée lorsque la valeur de seuil (U_{TS}) est dépassée.

10. Procédé selon la revendication 8, **caractérisé en ce que,** pour effectuer une mesure de courant, le conducteur individuel (10) connecté est commuté sur une source d'énergie électrique (16) liée à la masse de test (TGND) et la grandeur électrique (U_{ADC}, I_{T}) résultante liée à la masse de test (TGND) est mesurée.

11. Procédé selon la revendication 10, **caractérisé en ce que** le conducteur individuel (10) connecté est commuté sur une source de courant servant de source d'énergie électrique (16) et le conducteur individuel (10) est soumis à un courant de test (I_{T}) et la tension (U_{ADC}) liée à la masse de test (TGND) est mesurée et comparée à une valeur de seuil (U_{TS}) et une erreur (F) sur le conducteur individuel (10) est détectée lorsque la valeur de seuil (U_{TS}) est dépassée.

12. Procédé selon la revendication 10, **caractérisé en ce que** le conducteur individuel (10) connecté est commuté sur une source de tension servant de source d'énergie électrique (16) et le conducteur individuel (10) est soumis à une tension (U_{ADC}) et le courant de test (I_{T}) lié à la masse de test (TGND) est mesuré et comparé à une valeur de seuil (I_{TS}) et une erreur (F) sur le conducteur individuel (10) est détectée lorsque la valeur seuil (I_{TS}) est dépassée.

13. Procédé selon l'une des revendications 8 à 12, **caractérisé en ce que** la première extrémité du câble à tester (7) est reliée simultanément à une première unité de système (30) et à la première unité de test (2) et l'autre extrémité du câble à tester (7) est reliée simultanément à une seconde unité de système (31) et à la seconde unité de test (3).
